# EUROPEAN PATENT SPECIFICATION

(11) **EP 1 691 418 B1**
(45) Date of publication and mention of the grant of the patent: **26.11.2008**
(21) Application number: 06250392.5
(22) Date of filing: 25.01.2006
(51) Int. Cl.: H01L 27/146, H01L 27/148

(54) **Image sensor using deep trench isolation**
Bildsensor mit tiefer Grabenisolation
Capteur d'image avec isolation à rainure profonde

(30) Priority: 14.02.2005 US 58055
(43) Date of publication of application: 16.08.2006
(73) Proprietor: OmniVision Technologies, Inc., Sunnyvale, California 94089 (US)
(72) Inventor: Rhodes, Howard E., Boise, Idaho 83706 (US)
(74) Representative: Hackney, Nigel John

(56) References cited:
- EP-A- 0 499 083
- EP-A- 1 376 701
- EP-A- 1 641 045
- T.S.CHANG AND D.L. CRICHLOW: "Vertical FET random-access memories with deep trench isolation" IBM TECHNICAL DISCLOSURE BULLETIN, vol. 22, no. 8b, January 1980 (1980-01), pages 3683-3686, XP002381870
- BHATTACHARYA S ET AL: "Design issues for achieving latchup-free, deep trench-isolated, bulk, non-epitaxial, submicron CMOS" IBM TECHNICAL DISCLOSURES BULLETIN, 9 December 1990 (1990-12-09), pages 185-188, XP010554665

## Description

The present invention relates to image sensors, and more particularly, to image sensors using a deep trench isolation structure to reduce cross-talk between pixels.

Image sensors, whether of the CMOS or CCD variety, are becoming more highly integrated. One result of this higher integration is the reduction of size for each of the pixels in the image sensor. However, it has been found that as image sensor pixel size decreases, the amount of cross-talk between adjacent pixels becomes more of an important issue. In general, cross-talk can be generated from two different sources: (1) optical cross-talk which refers to the ability to optically focus incident light over a pixel through its microlens and onto the appropriate photosensitive element; and (2) electrical cross-talk which refers to the ability to collect the generated photocarriers in the photosensitive element where they are originally generated.

Currently, generated photocarriers (electrons) are not entirely collected in the photosensitive element where they were originally generated. This is because the photogenerated carriers can diffuse to adjacent photosensitive structures. One method to electrically isolate adjacent pixels is to define deep P-well implanted regions around each pixel. The deep P-well regions are electrically connected to the substrate potential and isolate one pixel from another. However, one drawback of this approach is that some incident photons, especially longer wavelength photons, generate electrons deep in the silicon photosensitive element.

To avoid losing the signal from the long wavelength photons, the lightly doped P-type region of the photosensitive element is deep, typically requiring an epitaxial layer thickness that is greater than 4 microns. This results in the isolating deep P-well to be also typically greater than 4 microns, which would require a B11 implant of about 2.4MeV, which in turn would require a resist thickness of about 8 microns. However, a thick photoresist cannot be used to pattern fine geometries.

As one example of the current state of the art, sub-3 micron pixels have a separation between pixels of about 0.4 microns. Typically, the thickest photoresist that can be used to pattern a 0.4 micron opening is about 2 microns thick. However, a 2 micron thick photoresist will only block a B11 implantation to a maximum energy of about 600KeV (or about 1 micron depth penetration). A deep P-well isolation that is only 1 micron deep cannot completely isolate the pixels. Further, a lightly doped epitaxial layer having a thickness of I micron would degrade the quantum efficiency and the sensitivity of the image sensor. Thus, the current technology is not completely effective and an improved process is advantageous. Document EP-A-0 499 083 discloses a CCD device with trench isolations. Document EP-A-1 376 701 discloses a CMOS imaging device with deep trenches.

In a first aspect, the present invention provides a pixel array according to Claim 1.

### BRIEF DESCRIPTION OF THE DRAWINGS

Figure 1 is a cross-sectional view of a prior art image sensor illustrating the cross-talk issue.

Figure 2 is a cross-sectional view of an image sensor showing a first embodiment of the present invention.

Figure 3 is a cross-sectional view of an image sensor in accordance with an alternative embodiment of the present invention.

Figures 4-6 are cross-sectional views showing how the deep trench isolations of the present invention can be formed.

Figures 7-8 show cross-sectional illustrations of the steps in forming a deep trench isolation in accordance with an alternative embodiment of the present invention.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment is included in at least one embodiment of the present invention. Thus, the appearances of the phrase "in one embodiment," or "in an embodiment" in various places throughout the specification are not necessarily all referring to the same embodiment. Furthermore, the particular features, structures, or characteristics may be combined in any suitable manner in one or more embodiments.

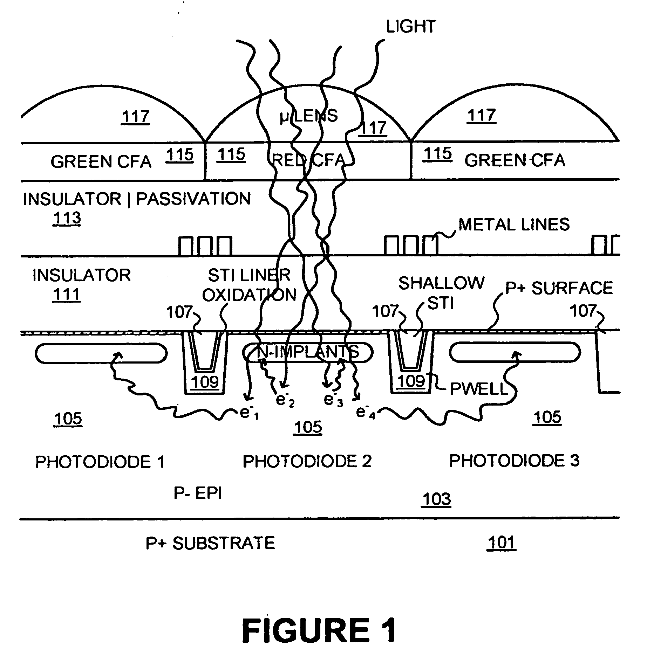

Turning to Figure 1, a cross-sectional view of a prior art image sensor is shown. In the view of Figure 1, three adjacent pixels are shown. Note that the precise internal structure of the pixel is not particularly germane to the present invention, and indeed, the present invention may be utilized with any CCD or CMOS pixel design, including but not limited to 3T, 4T, 5T, 6T, 7T, or other pixel designs. Moreover, throughout the description, the term "photosensitive element" is meant to encompass any type of structure that is sensitive to incident radiation, such as, including without limitation, photogates, photodiodes, pinned photodiodes, partially pinned photodiodes, etc. In Figure 1, the photosensitive element is a photodiode that is formed by an N' implant within the p-type layer or substrate.

As seen in Figure 1, a P-type substrate 101 has formed thereon a P' epitaxial layer 103. While in this embodiment, a P' epitaxial layer is used, the present invention may also be used where the P' epitaxial layer is omitted. Three pixels are shown in cross-section with prior art shallow trench isolations (STI) 107 used to aid in electrically isolating the photodiodes. However, as noted above, the STIs 107 are insufficient to completely isolate the photodiodes. Further, P-wells 109 are formed to further aid in the isolation. Note that in general, the P-wells 109 extend deeper than the STIs 107. Still, for the reasons noted above, the P-wells 109 are difficult to make deep enough to provide full isolation. Atop the surface of the P' epitaxial layer 103 are conventional insulator layers 111, passivation layer 113, color filter layer 115, and micro lenses 117. These layers are used to focus incident light, implement color image sensors, and provide various interconnect structures and insulation. Further, active structures, such as transistors, within each pixel are not shown for clarity. Note that while the present invention is described in terms of an n-channel transistors formed in a p-type substrate, the dopant types may be changed to accommodate p-channel transistors by using an n-type substrate. Additionally, the present invention is applicable to the formation of deep trench isolations with implanted isolating n-wells in the case where p-channel transistors are used.

Incident light onto the pixel may come in at various angles and because of the particular physical characteristics of the pixels, generated signal in the form of electrons in the photosensitive elements may in fact cause signal to be read out from adjacent pixels. This is the cross-talk issue that the present invention addresses.

To provide some specific context of the prior art, the P' epitaxial layer 103 is typically about 4 microns thick, which is about as thin as the epitaxial layer may be made using current technology. Note that in Figure 1, light that passes through the red color filter of the center pixel has a longer wavelength and is thus absorbed deeper in the silicon. The created electrons e₁, e₂, e₃, and e₄ are free to diffuse and the diffusion of these electrons is a "random walk."

In order to address this issue, the present invention uses a deep trench isolation in the image sensor array. The STI technology shown in Figure 1 is typically on the order of 0.3 to 0.5 microns deep with a P-well 109 that is approximately 1 micron deep. The present invention takes advantage of the selectivity of silicon etching to photoresist erosion to make it possible to generate trenches in the silicon P⁻ epitaxial layer 103 that are relatively deep. The deep trench isolation can be used to isolate a pixel from its adjacent pixels.

As further detailed below, the sidewalls of the trench and the bottom of the trench are implanted in order to passivate the surface states and localized defects and to prevent generation of electrons near the trench. This can be accomplished by implanting the trench with a P-type dopant. For example, in accordance with the present invention, the deep trench isolation may be 4 microns deep. Alternatively, as will be seen further below, a combination of a deep trench isolation and a P-well isolation may be used. Because the depth of the deep trench isolation is much deeper than the prior art, it is less necessary to implant the B11 ion to a depth of 4 microns, and instead, much shallower P-well implants may be used. In other words, because the "starting point" of the implant (the level of the bottom of the deep trench) is deeper, the B 11 ions do not need to penetrate into the substrate as deeply.

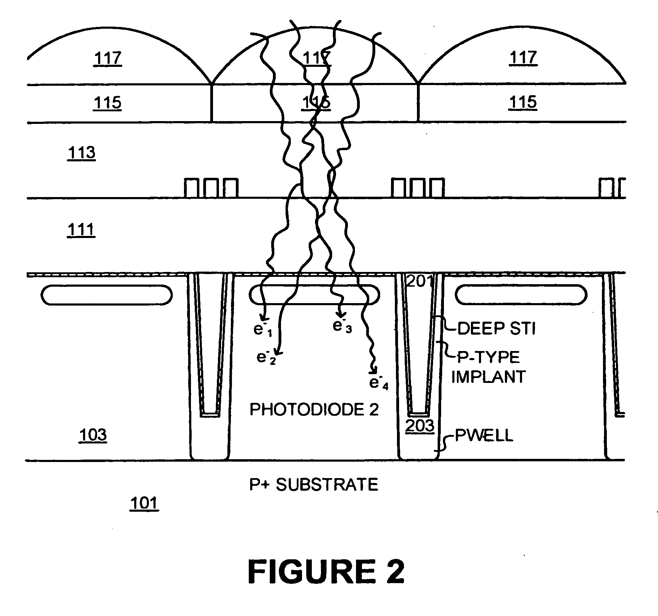

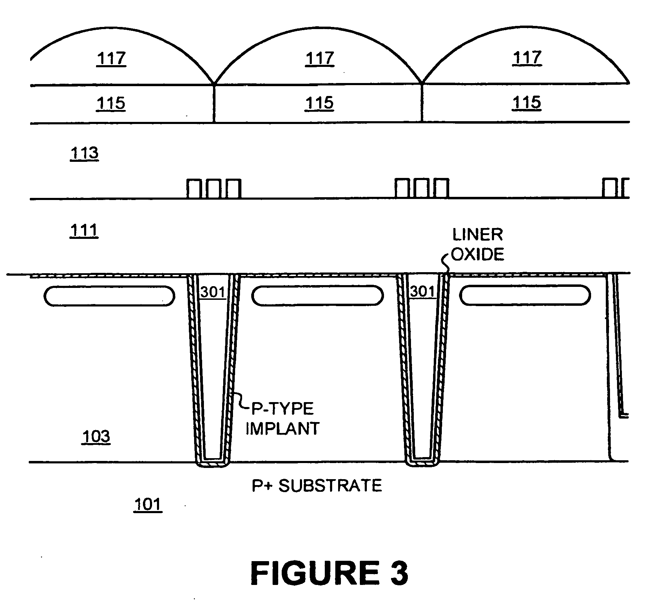

Turning to Figure 2, a cross-sectional view of an image sensor pixel array showing three pixels and using the deep trench isolation of the present invention is shown. By extending the deep trench isolation 201 down into the epitaxial layer 103, an enhanced isolation can be achieved. Additionally, by forming the deep trench isolation by more deeply etching the epitaxial layer 103, the P-well 203 can be formed using still relatively low implant energies. In one embodiment, the deep trench isolation 201 is on the order of 2 microns deep, but may extend further into the epitaxial layer 103 and even through the epitaxial layer 103 into the substrate 101. In the embodiment shown in Figure 2, the deep trench isolation does not go all the way to the P substrate layer 101. Turning to Figure 3, in this alternative embodiment, the deep trench isolation extends all the way to the P-type substrate 101.

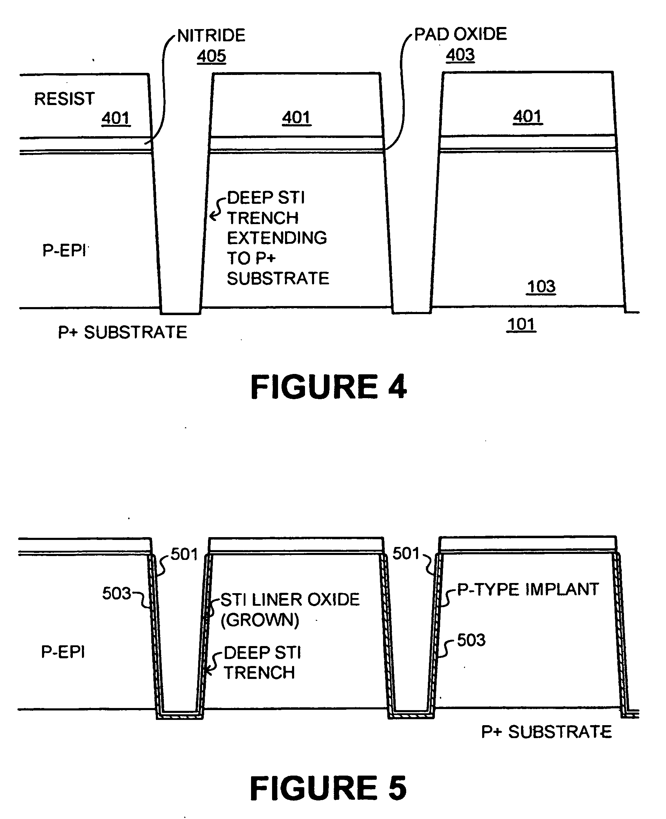

Figures 4-6 illustrates a method of forming the embodiment of Figure 3. Specifically, turning to Figure 4, after the P' epitaxial layer 103 has been grown or otherwise formed, a photoresist layer 401 is patterned in accordance with the deep trench isolation pattern that separates the pixels. Typically a pad oxide 403 and a nitride layer 405 is formed underneath the photoresist layer 401 and is used in conventional CMOS processes in order to perform various stress relieving, stop layer, and other functions. However, it can be appreciated that other types of intervening layers between the photoresist 401 and the epitaxial layer 103 may be used, and even no intervening layers may be used. Once the photoresist layer 401 has been patterned, an etching step, such as an anisotropic reactive ion etch may be used to etch a trench 407 in the epitaxial layer 103. The trench 407 is deeper than the conventional STIs, and would typically be 1 micron or more in depth.

Next, turning to Figure 5, the photoresist layer 401 is removed and the image sensor surface is cleaned. Next, a liner oxide layer 501 is grown and a shallow P' implant is performed in order to passivate the surface states and localized defects and to prevent generation of electrons near the trench. In one embodiment, the P-type implant has a dopant concentration of 5e11 to 2e13 ions/cm² and implanted with an energy of 5 to 100 keV. Note that the passivating P' implant is optional. Note that the liner oxide layer 501 is an optional step, as is the shallow P' implant. The liner oxide 501 may be between 20-200 angstroms thick, and further, may be an oxide/nitride stack where the nitride layer is between 20-200 angstroms thick.

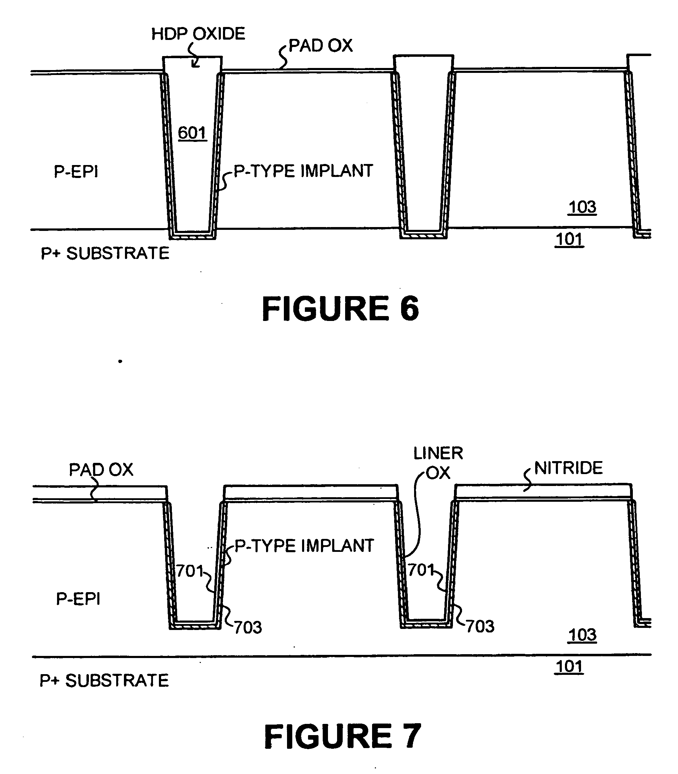

Turning to Figure 6, an oxide is deposited into the deep trench isolation opening. The oxide, in one embodiment may be a high density plasma chemical vapor deposition (HDPCVD) oxide. The HDPCVD oxide is chosen for its ability to fill high aspect ratio openings; however any type of oxide or dielectric may be used to form the deep trench isolation 601. Alternatively, a spin-on-glass (SOG) may be used to fill the deep trench isolation opening. After the formation of the HDPCVD or SOG oxide, a chemical mechanical processing (CMP) step may be used to planarize the surface. Note that the embodiment of Figure 6 does not require the use of a P-well because of the depth of the deep trench isolation.

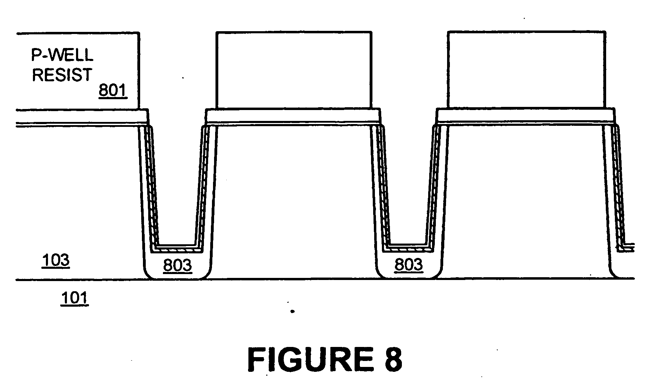

Figure 7 shows a cross-sectional view of an image sensor pixel array that forms a deep trench isolation that does not extend all the way through the epitaxial layer 103. In this embodiment, the photoresist is patterned as in Figure 4. However, the epitaxial layer 103 is not etched all the way through and the opening of the trench extends only partially through the epitaxial layer 103. Thus, Figure 7 is substantially similar to Figure 5, after the P' implant 703 and the liner oxide layer 701 is formed, except that the trench opening does not extend all the way through the epitaxial layer. Next, turning to Figure 8, a P-well photomask is formed that will allow a P-well implant to be used that extends the isolation depth to the P-plus substrate 101. Thus, a P-well 803 is formed by the implant, but the implant is performed using a relatively low energy, and generally lower than that of the prior art. In one embodiment, the energy of the implant is on the order of 50 to 500 keV. Thus, in this embodiment, the deep trench isolation is used in combination with the P-well 803.

Note that the deep trench isolation that extends all the way to the substrate 101 may be advantageous in that the P' (Figure 6) is self-aligned to the deep trench isolation oxide. In the embodiment of Figure 8, the P-well 803 is not self-aligned to the deep trench isolation. Note further that the deep trench isolation provides a deeper isolation by itself without the use of a P-well. However, for various reasons, the deep trench isolation may be more difficult to manufacture.

Further, the present description only describes the formation of the deep trench isolation and does not go on to describe formation of the actual structures within the pixel, which are well known in the art. This is to avoid obscuring the present invention as the steps in forming the active devices within the pixel are well known in the art.

From the foregoing, it will be appreciated that specific embodiments of the invention have been described herein for purposes of illustration, but that various modifications may be made without deviating from the scope of the invention. Accordingly, the invention is not limited except as by the amended claims.

## Claims

1. A pixel array comprising:
an epitaxial layer (103) formed over a semiconductor substrate (101);
a plurality of pixels arranged in a pattern and formed in the epitaxial layer;
deep trench isolations (201, 301, 601) formed in said epitaxial layer, said deep trench isolations separating adjacent pixels of at least a portion of said plurality of pixels;
**characterized in that**:
the deep trench isolations extend through substantially the entire epitaxial layer.

2. The pixel array of Claim 1 further including a P-well (203, 803) formed beneath said deep trench isolations (201, 301, 601).

3. The pixel array of Claim 2 wherein said P-well (203, 803) is formed from an implant energy of less than 500 keV.

4. The pixel array of Claim 1 wherein said epitaxial layer (103) is p-type.

5. The pixel array of Claim 1 wherein said deep trench isolations (201, 301, 601) have their sidewalls doped with a p-type dopant (503, 703).

6. The pixel array of Claim 1 wherein said deep trench isolation (201, 301, 601) is formed by using a high density plasma chemical vapor deposition (HPDCVD) process or spin-on-glass (SOG).

7. The pixel array of Claim 1 wherein said plurality of pixels are 3T, 4T, 5T, 6T, or 7T pixels.

8. The pixel array of Claim 1 wherein said semiconductor substrate (101) is n-type.

9. The pixel array of Claim 8 further including an N-well formed beneath said deep trench isolations (201, 301, 601).

10. The pixel array of Claim 1 wherein said epitaxial layer (103) and semiconductor substrate (101) is n-type.

11. The pixel array of Claim 10 further including an N-well formed beneath said deep trench isolations (201, 301, 601).

12. The pixel array of Claim 1 wherein said deep well isolations (201, 301, 601) have a liner layer (501, 701) formed from either oxide or an oxide/nitride stack with a thickness of between 20-200 angstroms.

13. The pixel array of Claim 1 wherein said pixel array is part of a CCD image sensor.

14. The pixel array of Claim 1 wherein the deep trench isolations (201, 301, 601) extend through the epitaxial layer (103) and into the substrate.

15. The pixel array of Claim 1 wherein the deep trench isolations (201, 301, 601) are formed from an oxide.

## Patentansprüche

1. Pixelmatrix, umfassend:
eine Epitaxialschicht (103), die über einem Halbleitersubstrat (101) ausgebildet ist:
eine Vielzahl an in einem Muster angeordneten und in der Epitaxialschicht ausgebildeten Pixeln;
Deep-Trench-Isolierungen (201, 301, 601), die in der Epitaxialschicht ausgebildet sind, wobei die Deep-Trench-Isolierungen aneinander angrenzende Pixel von zumindest einem Anteil der Vielzahl an Pixeln trennen;
**dadurch gekennzeichnet, dass**
sich die Deep-Trench-Isolierungen durch im Wesentlichen die gesamte Epitaxialschicht erstrecken.

2. Pixelmatrix nach Anspruch 1, ferner umfassend eine unterhalb der Deep-Trench-Isolierungen (201, 301, 601) ausgebildete p-Wanne (203, 803).

3. Pixel matrix nach Anspruch 2, worin die p-Wanne (203, 803) aus einer Implantationsenergie von weniger als 500 keV gebildet ist.

4. Pixelmatrix nach Anspruch 1, worin die Epitaxialschicht (103) vom p-Typ ist.

5. Pixelmatrix nach Anspruch 1, worin die Deep-Trench-Isolierungen (201, 301, 601) eine Dotierung ihrer Seitenwände mit einem Dotierungsmaterial vom p-Typ (503, 703) aufweisen.

6. Pixelmatrix nach Anspruch 1, worin die Deep-Trench-Isolierung (201, 301, 601) mittels chemischer Gasphasenabscheidung aus Plasma mit hoher Dichte (HPDCVD) oder mittels eines Spin-on-Glass-Verfahrens gebildet ist.

7. Pixelmatrix nach Anspruch 1, worin die Vielzahl an Pixeln 3T-, 4T-, 5T-, 6T- oder 7T-Pixel ist.

8. Pixelmatrix nach Anspruch 1, worin das Halbleitersubstrat (201) vom n-Typ ist.

9. Pixelmatrix nach Anspruch 8, ferner umfassend eine unterhalb der Deep-Trench-Isolierungen (201, 301, 601) ausgebildete n-Wanne.

10. Pixelmatrix nach Anspruch 1, worin die Epitaxialschicht (103) und das Halbleitersubstrat (101) vom n-Typ sind.

11. Pixelmatrix nach Anspruch 10, ferner umfassend eine unterhalb der Deep-Trench-Isolierungen (201, 301, 601) ausgebildete n-Wanne.

12. Pixelmatrix nach Anspruch 1, worin die Deep-Well-Isolierungen (201, 301, 601) eine Auskleidungsschicht (501, 701) aufweisen, die entweder aus Oxid oder einem Oxid-Nitrid-Stapel mit einer Dicke von zwischen 20 bis 200 Å besteht.

13. Pixelmatrix nach Anspruch 1, worin die Pixelmatrix Teil eines CCD-Bildsensors ist.

14. Pixelmatrix nach Anspruch 1, worin sich die Deep-Trench-Isolierungen (201, 301, 601) durch die Epitaxialschicht (103) und in das Substrat erstrecken.

15. Pixelmatrix nach Anspruch 1, worin die Deep-Trench-Isolierungen (201, 301, 601) aus einem Oxid gebildet sind.

## Revendications

1. Matrice de pixel comprenant :
une couche épitaxiale (103) formée sur un substrat semi-conducteur (101) ;
une pluralité de pixels agencés en motif et formés dans la couche épitaxiale ;
des séparations en tranchée profonde (201, 301, 601) formées dans ladite couche épitaxiale, lesdites séparations en tranchée profonde séparant des pixels adjacents d'au moins une partie de ladite pluralité de pixels ;
**caractérisée en ce que** :
les séparations en tranchée profonde s'étendent à travers sensiblement la totalité de la couche épitaxiale.

2. Matrice de pixel selon la revendication 1, comprenant en outre un puits P (203, 803) formé sous lesdites séparations en tranchée profonde (201, 301, 601).

3. Matrice de pixel selon la revendication 2, dans laquelle ledit puits P (203, 803) est formé à partir d'une énergie d'implant inférieure à 500 keV.

4. Matrice de pixel selon la revendication 1, dans laquelle ladite couche épitaxiale (103) est de type p.

5. Matrice de pixel selon la revendication 1, dans laquelle lesdites séparations en tranchée profonde (201, 301, 601) ont leurs parois dopées avec un dopant de type p (503, 703).

6. Matrice de pixel selon la revendication 1, dans laquelle ladite séparation en tranchée profonde (201, 301, 601) est formée en utilisant un procédé de dépôt chimique en phase vapeur à forte densité de plasma (HPDCVD) ou un verre déposé par centrifugation (SOG).

7. Matrice de pixel selon la revendication 1, dans laquelle ladite pluralité de pixels est constituée de pixels à 3 transistors, 4 transistors, 5 transistors, 6 transistors ou 7 transistors.

8. Matrice de pixel selon la revendication 1, dans laquelle ledit substrat semi-conducteur (101) est de type n.

9. Matrice de pixel selon la revendication 8, comprenant en outre un puits N formé sous lesdites séparations en tranchée profonde (201, 301, 601).

10. Matrice de pixel selon la revendication 1, dans laquelle ladite couche épitaxiale (103) et le substrat semi-conducteur (101) sont de type n.

11. Matrice de pixel selon la revendication 10, comprenant en outre un puits N formé sous lesdites séparations en tranchée profonde (201, 301, 601).

12. Matrice de pixel selon la revendication 1, dans laquelle lesdites séparations en puits profond (201, 301, 601) ont une couche de revêtement (501, 701) formée à partir soit d'une oxyde, soit d'un empilement oxyde/nitrure ayant une épaisse comprise entre environ 20 et 200 angströms.

13. Matrice de pixel selon la revendication 1, dans laquelle ladite matrice de pixel fait partie d'un capteur d'image CCD (dispositif à couplage de charge).

14. Matrice de pixel selon la revendication 1, dans laquelle les séparations en tranchée profonde (201, 301, 601) s'étendent à travers la couche épitaxiale (103) et dans le substrat.

15. Matrice de pixel selon la revendication 1, dans laquelle les séparations en tranchée profonde (201, 301, 601) sont formées à partir d'un oxyde.
